# EUROPEAN PATENT APPLICATION

(11) **EP 1 976 363 A1**
(43) Date of publication of application: **01.10.2008**
(21) Application number: 07105338.3
(22) Date of filing: 30.03.2007
(51) Int. Cl.: H05K 13/02, H05K 13/04

(54) **A device at a component mounting machine**

(71) Applicant: Mydata Automation AB, 168 66 Bromma (SE)
(72) Inventor: Axelsson, Robert, 125 74, ÄLVSJÖ (SE)
(74) Representative: Skagersten, Thomas

(57) **Abstract**

This invention relates to a component magazine for a component mounting machine. The component magazine comprises a lower part including a feeding device, and an upper part including tube holders. The upper part is mounted at the lower part, and is reciprocatingly movable along the lower part by means of the feeding device. The upper part is provided with at least one fiducial mark (122), and has a component reception portion (124) where components are received from tubes (114) and aligned in a picking position. The component reception portion is provided with a component receiver holding means (145) having a fixed position in relation to said at least one fiducial mark, and one or more component receivers, fastened at said component receiver holding means, and defining one or more picking positions for the components on said component reception portion.

Therefore, by means of a common vision device of a component mounting machine, the fiducial mark(s) is/are detectable, and the upper part is adjustable by means of the feeding device into an accurate position enabling component picking.

## Description

### FIELD OF THE INVENTION

The present invention relates to a component magazine for a component mounting machine.

### BACKGROUND OF THE INVENTION

One type of component mounting machines uses components consecutively stored in elongate plastic tubes. The tubes are loaded in a vibrating magazine, such as for example VMF30 manufactured by MYDATA AB. The components within the tubes are moved forward by vibrating the magazine both longitudinally and vertically thereof. Each tube has been mounted in the magazine in such a way that a forward end thereof abuts against a stop at a component receiver. The component receiver serves in providing a stop for the forward movement of the components, and in providing a well defined picking position. Thus, the position of the component receiver determines the picking position for the component in the tube, and the position of the component receiver is adjustable by means of a fastening screw, which extends through a slit of the component receiver into a fixed seat in a base. When the screw is slightly loosened the component receiver is displaceable along the slit relative to the screw.

A picking head is arranged on an X wagon, which is movable along an X axis. A substrate, on which the components are going to be mounted, is arranged on a Y wagon, which is movable along a Y axis, extending perpendicular to the X axis.

Component mounting machines demand that a component which is to be picked has a well defined position, known to the machine in advance. Components which have such a well defined position known by the software of the machine are called located components, or components having located picking positions. In the prior art machines, before the mounting can begin, a manual locating operation is performed as follows. The component mounting machine comprises a camera or some other vision device, which is mounted on the X wagon, and which is used by the machine during the mounting procedure. For each tube, an operator, looking at the image generated by the camera, moves the camera to the picking position of the component that is received by the component receiver. The operator indicates the picking position to the machine software. This operation often includes a position adjustment of the component receiver as well, in order to align the component with a desired picking position.

This conventional manual locating operation is time consuming, and has to be repeated if the magazine is removed from the machine and loaded into another machine or is reloaded into the same machine. This is due to various tolerances between different parts at interfaces between them.

### SUMMARY OF THE INVENTION

It is an object of the present invention to provide a component magazine that alleviates the above-mentioned drawbacks of the prior art, such that the manual locating operation is eliminated or at least such that the time consumption thereof is reduced.

This object is achieved by a component magazine according to the present invention as defined in the appended claims.

Thus, in accordance with an aspect of the present invention, there is provided a component magazine for a component mounting machine, which component magazine comprises a lower part including a feeding device, and an upper part including a tube holder. The upper part is mounted at said lower part, and is reciprocatingly movable along said lower part by means of said feeding device. Furthermore, the upper part is provided with at least one fiducial mark, and has a component reception portion where components are received from tubes and aligned in a picking position. The component reception portion is provided with a component receiver holding means having a fixed position in relation to said at least one fiducial mark, and at least one component receiver, which is/are fastened at the component receiver holding means, and which define at least one respective picking position for the components on said component reception portion.

Since the upper part of the magazine is provided with one or more fiducial marks and is movable along the lower part, the machine vision system can be used for detecting the fiducial mark(s) and adjusting the position of the upper part in accordance with the fiducial mark(s). Having, thus, positioned the upper part, the component receiver holding means is automatically positioned, since it has a fixed position relative to the fiducial mark(s). It should be noted that in the description of embodiments below only embodiments having two fiducial marks are shown and described. However, as evident from the claims, the object of the invention is achieved with merely one fiducial mark. In fact in some embodiments, such as those having a narrow upper part, it can be advantageous to have a single fiducial mark, because the time for locating the fiducial marks is reduced. On the other hand, there are advantages in using several fiducial marks, which is in accordance with an embodiment of the component magazine, over using a single fiducial mark as well, in particular on broad upper parts. For example, possible angular mismatch between the upper part and a movement line of a picking head will be compensated for.

In accordance with an advantageous embodiment of the component magazine, each respective component receiver comprises a component positioning surface, which is arranged at a predetermined fixed position relative to the component receiver holding means at which it is fastened, thereby providing a predetermined fixed picking position. Hence, according to this embodiment, a very small tolerance is obtained for the final picking position, which can be said to be a default position. As an alternative the component receivers are adjustably mounted at the holding means. Then, an initial manual adjustment may be needed, while a good repeatability is obtained due to the fiducial mark, or marks. That is, if the magazine is unloaded from the machine, no manual adjustment will be required at reloading.

In accordance with an advantageous embodiment of the component magazine, each respective component receiver has a snap-in socket, by which it is attached to the component receiver holding means. Thereby a default picking position is secured, since the position of the component receiver is unambiguously determined by the fixed position of the component receiver holding means.

In accordance with an advantageous embodiment of the component magazine, the component receiver holding means is rigidly connected with the at least one fiducial mark. Consequently, the picking position is well defined, possibly except for a minimal tolerance generated at production of the upper part of the magazine. That tolerance, as is evident to a skilled person, is negligible in this context.

In accordance with an advantageous embodiment of the component magazine, the upper part is demountable from the lower part. Due to the fiducial mark(s) there is no need for any manual adjustment when remounting an upper part that has been demounted.

These and other aspects, features, and advantages of the invention will be apparent from and elucidated with reference to the embodiments described hereinafter.

### BRIEF DESCRIPTION OF THE DRAWINGS

The invention will now be described in more detail and with reference to the appended drawings in which:

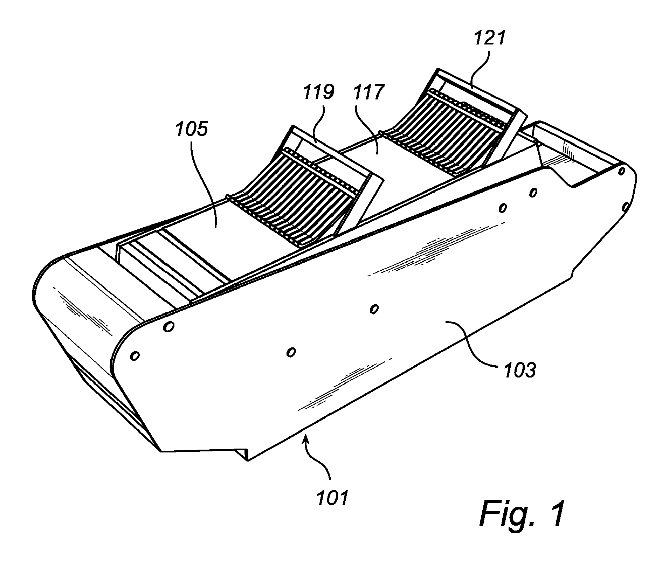

Fig. 1 is a perspective view of an embodiment of a component magazine according to the present invention;

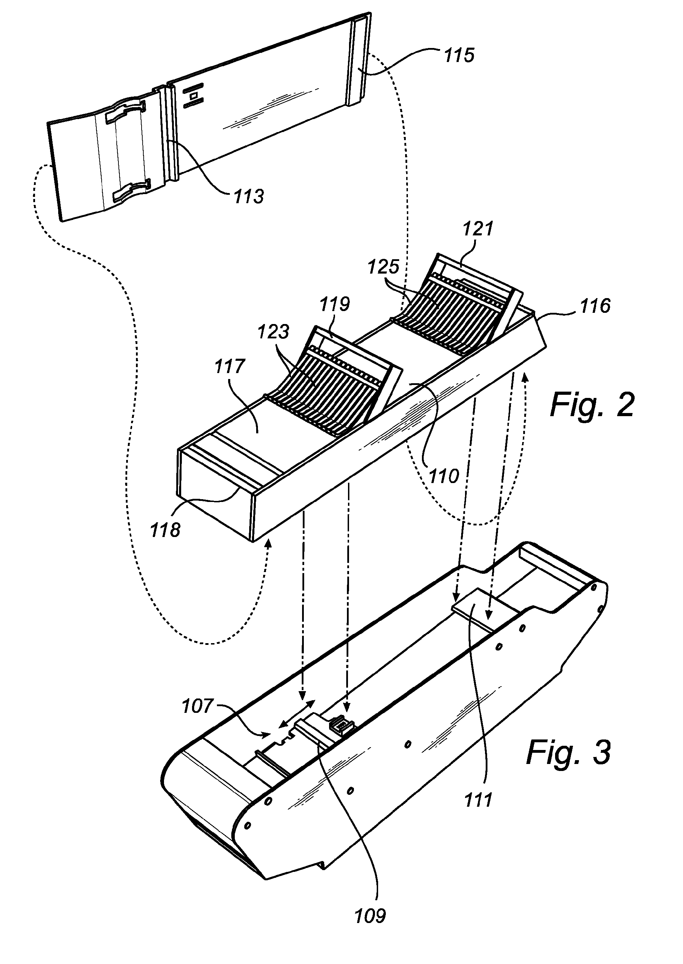

Fig. 2 is a perspective view of an upper part of the magazine shown in Fig. 1;
Fig. 3 is a perspective view of a lower part of the magazine in Fig. 1;
Fig. 4 is a top plan view of the upper part in fig. 2;
Fig. 5 is a top plan view of one embodiment of a component receiver;
Fig. 6 is a perspective view of another embodiment of a component receiver;
Fig. 7 is atop plan view that illustrates the movements of movable parts of a component mounting machine;
Fig. 8 is a top plan view of a further embodiment of a component receiver;
Fig. 9 is a perspective view of a part of an upper part of a magazine; and
Fig. 10 is a cross-sectional view of a further embodiment of a component receiver.

### DESCRIPTION OF PREFERRED EMBODIMENTS

An embodiment of a component magazine 101 according to the present invention has two main parts, a lower part 103, and an upper part 105, which is demountably connected with the lower part 103. In the following, for the purposes of this description, the upper part 105 will be referred to as a pallet 105.

The lower part 103 is provided with a feeding device 107 having front and rear carrier members 109, 111 for carrying the pallet 105. The pallet 105 comprises a base plate 110 and is provided with front and rear engagement portions 113, 115, arranged at a bottom side of the base plate 110, which are engaged with the respective carrier members 109, 111. In this embodiment the engagement portions 113, 115 are demountable from the carrier members 109, 111. The feeding device 107 is of a type which per se is well known to a person skilled in the art, and therefore it is not illustrated in detail. In short the feeding device 107 includes a motor which moves the front carrier member 109, and thus the pallet 105, reciprocatingly in a way that moves the components forward. The rear carrier member 111 is a mere slide plate, on top of which the rear engagement portion 115 slides back and forth. The reciprocating movement is fast, and to an observer it looks like the pallet 105 vibrates. Therefore vibration is a term that will be used in addition below.

The pallet 105 is a support for tubes holding components, which are to be mounted. The tubes are fed along the top surface 117 of the base plate 110 from a first end 116 of the pallet 105 towards a second end 118 thereof past two tube holders bars 119, 121, fixed as two arcs across the base plate 110, into abutment against component receivers 120 mounted at a component reception portion 124 of the pallet 105 close to the second end 118 thereof. Each tube holder bar 119, 121 is provided with a plurality, here 16, of tube holders 123, 125. The tube holders 123, 125 are sloping from the respective bar 119, 121 towards, and are prestressed against, the top surface 117.

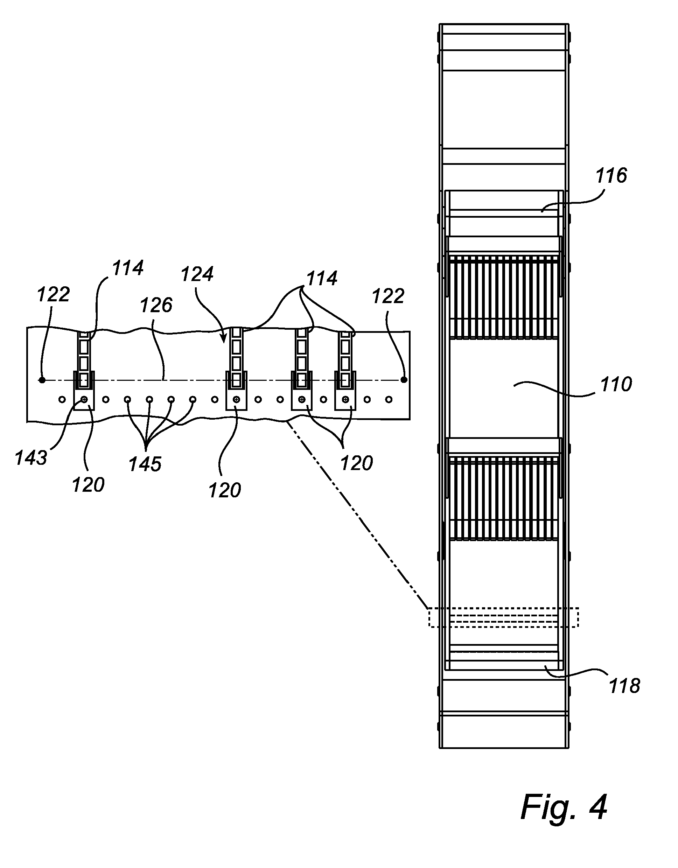

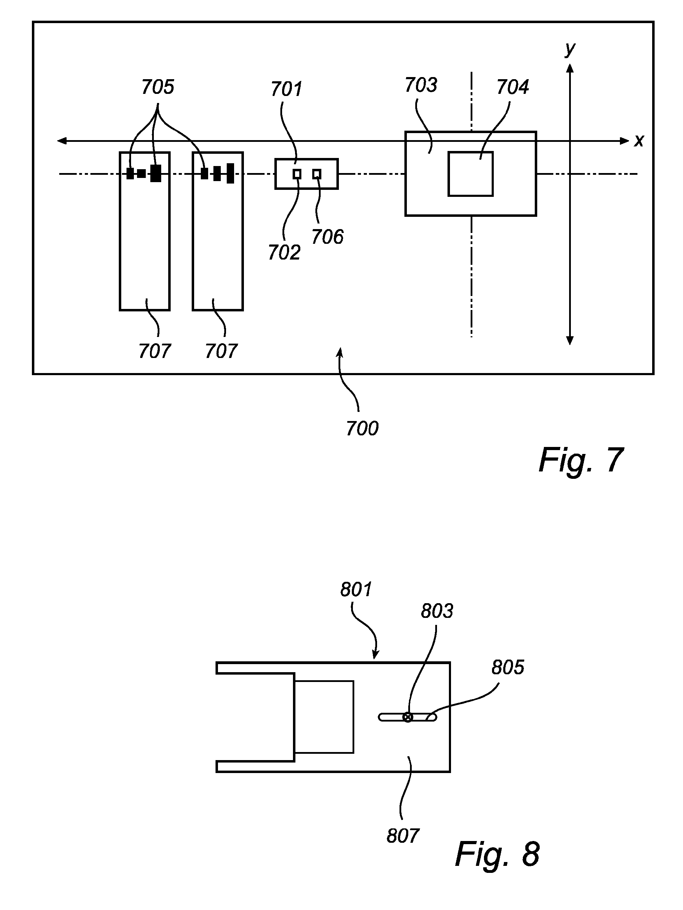

As shown in Fig. 7, a typical kind of component mounting machine 700 employing the present invention would be a so called split-axis machine having an X wagon 701, which is movable in an X direction and a Y wagon 703, which is movable in a Y direction perpendicular to the X direction. The X wagon 701 carries a component picking head 706 as well as a vision means, such as a camera, 702 for locating the component to be picked. The wagons and their associated parts are only shown most schematic, since they are per se well known. The Y wagon 703 carries the substrate 704, such as for example a PCB (Printed Circuit Board), on which the components 705 provided by the component magazines 707 are to be mounted. It is important that the components 705 are correctly aligned so that they can be correctly picked and placed on the substrate 704. In accordance with this invention the alignment is facilitated by fiducial marks, embodied as two dots 122 in the present embodiment, as illustrated in Fig. 4. In an enlarged view in Fig. 4 a component reception portion 124, which constitutes a portion of the pallet 105, is shown. The fiducial marks 122 are provided within the component reception portion 124 at opposite sides of the base plate 110, and thus of the pallet 105, and indicate a picking position line 126 extending straight between the fiducial marks 122. Thus, if the centres of the components to be mounted are positioned along the picking position line 126 they can be properly picked by the picking head 706. For that purpose a component receiver holding means, here embodied as component receiver holders 145, which each has a fixed position in relation to the fiducial marks 122, is arranged at the component reception portion 124. In the embodiment as shown in Fig. 4, the component receiver holders 145 are threaded holes arranged along a straight line in parallel with and at a small distance from the picking position line 126. The holes 145 are displaced towards the second end 118 in relation to the picking position line 126. Since the fiducial marks 122 and the component receiver holders 145 are integral with the base plate 110, the component receiver holders 145 are rigidly connected with the fiducial marks 122.

Component receivers 120 according to any one of several different embodiments, some of which will be described below, are fixed to the component receiver holding means, i.e. the component receiver holders 145. By having the screw fastening according to these embodiments the component receivers 120 as well are arranged at predetermined exact positions relative to the fiducial marks 122. The component receivers are arranged to receive a tube 114 each.

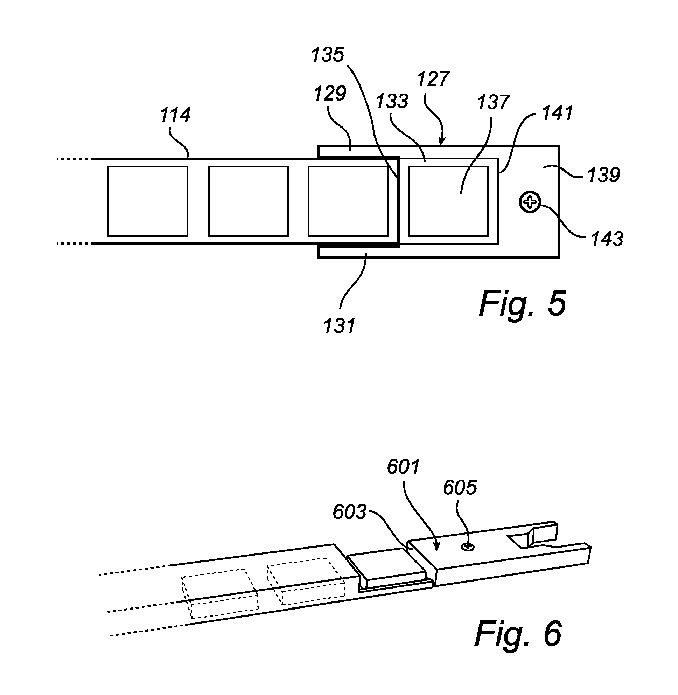

In Figs. 5 and 6 there are shown different embodiments of the component receivers 120. In one embodiment the component receiver 127 is fork shaped. The fork has two protruding guide pins 129, 131 between which the tube 114 is received, guided thereby. An inner portion of the space between the guide pins is provided with a bottom plate 133. When mounted the tube 114 is stopped at a front edge 135 of the bottom plate 133. When the pallet 105 is being vibrated, i.e. reciprocated, the front most component 137 within the tube 114 is moved forward onto the bottom plate 133.

The guide pins 129, 131 and the bottom plate 133 protrude from a rear portion, or fastening portion, 139 of the fork 127. The thickness of the bottom plate 133 is a fraction of the thickness of the fastening portion 139. At the transition between the bottom plate 133 and the fastening portion 139 there is a further edge 141, which serves as a stop for the movement of the component 137 and fixes the position thereof along the length of the pallet 105, which is in parallel with the Y axis direction. Consequently, this further edge serves as a component positioning surface. The fastening portion 139 comprises a component receiver fastener 143, which in this embodiment is embodied by a screw extending through the fastening portion 139 and a bit further downwards. The pallet 105 comprises component receiver holders 145, in this embodiment screw holes 145. The screw 143 is fastened into the screw hole 145. As an alternative, the component receiver fasteners are snap-in fasteners, which are snap-in locked to the component receiver holding means, as will be further described below.

In accordance with another embodiment, the component receiver 601 is turned back to front, and has a straight front edge 603, which is the rear edge when turned the right way, that serves as a stop for the tube 114. In order for the components 137 to be accessible an upper half of a front end portion of the tube has been cut off at a length that is slightly longer than the component 137. In this embodiment as well the component receiver 601 has a screw fastener 605. In this way, the front edge 603 of the block 601 additionally serves as a component positioning surface.

Referring to Fig. 8, a further component receiver 801 has an adjustable fastening position, such as by having the screw 803 extending through an elongate slit 805 formed in the fastening portion 807 of the component receiver 801, similar to the slit of the previous embodiment. Such a component receiver 801 is disadvantageous in that often the automatic locating operation is no longer possible to perform, but a manual adjustment of the component receivers will be necessary. However, in comparison with the prior art component magazines, this will still be advantageous, since the manual operation will only have to be performed once, when the magazine, or the pallet, is loaded for the first time at the component mounting machine. Then, if the pallet is temporarily removed and put back or moved to another magazine, or the like, due to the fiducial marks and the Y directional adjustability of the pallet, there will be no need for any additional manual adjustment.

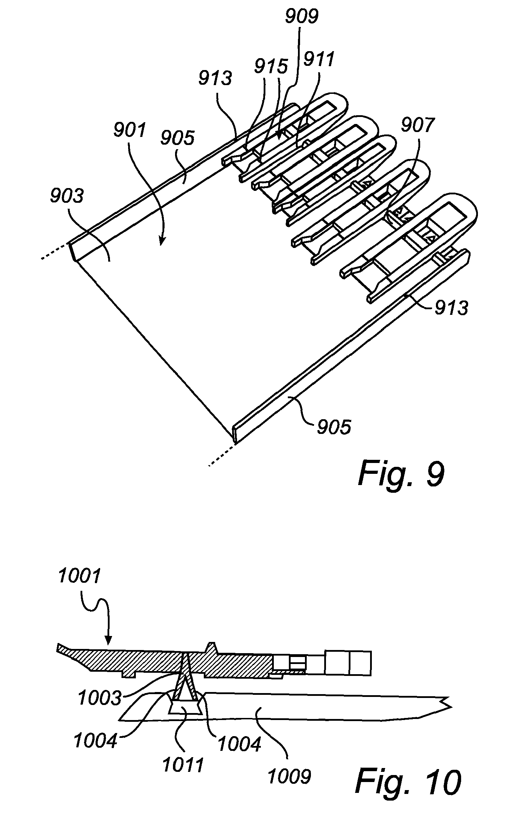

According to a further embodiment of the component magazine, the component receivers are provided with a snap-in fastener, as shown in Fig. 9. More particularly, the pallet 901, having a bottom plate 903 and elongate side walls 905, is provided with a component receiver holding means embodied as a single rail shaped holder, or simply rail, 907 extending straight across the bottom plate 903 between the side walls 905 close to a front end of the pallet 901. At a distance from the thus laterally extending rail 907, fiducial marks 913 are oppositely arranged on a respective narrow top surface of the side walls 905, one mark 913 at each side wall 905. The component receivers 909 are each provided with a snap lock portion 911. When the component receiver 909 is mounted at the pallet 901, the snap lock portion 911 engages with the rail 907, thereby locking the position of the component receiver 909. The receiving portion of the component receiver is arranged at a fixed distance from the snap lock portion 911, and this distance is accurately matched with the longitudinal distance between the rail 907 and the fiducial marks 913, such that the picking position of a component received by the component receiver 909 is aligned with a picking position line between the fiducial marks 913. As an extra security and as a support for the operator, the component receiver is provided with picking position markers 915, embodied as transverse lines on a top side of the component receiver 909 aligned with a centre position of a received component.

There are different applicable embodiments of the snap lock portion. For example, as illustrated in Fig. 10, according to a further embodiment the component receiver 1001 is provided with a snap lock pin 1003, which protrudes downwards from the bottom of the component receiver 1001. The snap lock pin 1003 has resilient tongues 1004 which are arranged to be received in a recess 1011 of the bottom plate 1009 of the pallet, which recess 1011 constitutes a component receiver holding means.

By means of the present invention, when starting up the component mounting machine the manual locating of components can be avoided, and replaced by an automatic locating operation as follows. Referring again to Fig. 7, when the component magazines 707 (101) have been loaded with tubes 114 and have been loaded at the component mounting machine 700 an automatic locating operation is initiated. Then the machine 700 moves the X wagon 701 until it reaches a first magazine 707. The camera 702 detects the fiducial marks 122 on the pallet 105, and image processing software determines any displacement of the picking head 706 from the desired picking line 126. If a correction is necessary, the machine 700 adjusts the pallet 105 by controlling the motor of the feeding device 107 to perform minor movements of the pallet 105 along the Y direction. Then, if one of the kinds of component receivers providing default picking positions are used, the machine is ready for the very component mounting operation.

Above, embodiments of the component magazine according to the present invention have been described. These should be seen as merely non-limiting examples. As understood by a skilled person, many modifications and alternative embodiments are possible within the scope of the invention as defined by the appended claims.

It should be noted that even if the invention has been described in conjunction with a split-axis machine, the invention is not limited to this type of machine. For example, it is equally applicable to a component mounting machine, in which the picking head is movable in both X and Y directions while the substrate is fixed during the component placement procedure. Such mounting machines are generally so called gantry machines, in which the picking head is mounted on a gantry and movable along the gantry in the X direction, which gantry is in turn movable in the Y direction, or vice versa. In that case, the machine will adjust the position of the gantry and/or picking head instead of the pallet, after detecting the fiducial marks on the pallet. Thus, for a gantry machine, the component magazines are provided with tubes and loaded to the component mounting machine in similar manner as described above, and an automatic locating operation is initiated. Then, the machine moves the gantry and picking head until a first magazine is reached. A camera detects fiducial marks on the pallet, and image processing software determines any displacement of the picking head from a desired picking line. If a correction is required, the machine then adjusts the gantry and/or the picking head, resulting in minor movements of the picking head along the Y direction in adaptation to the determined displacement, in preparation for an ensuing component mounting operation.

It is to be noted, that for the purposes of this application, and in particular with regard to the appended claims, the word "comprising" does not exclude other elements or steps, that the word "a" or "an", does not exclude a plurality, which per se will be apparent to a person skilled in the art.

## Claims

1. A component magazine for a component mounting machine, which component magazine 101 comprises a lower part 103 including a feeding device (107), and an upper part (105) including a tube holder (123, 125), wherein said upper part is mounted at said lower part, and is reciprocatingly movable along said lower part by means of said feeding device, wherein said upper part is provided with at least one fiducial mark (122), and has a component reception portion (124) where components are received from tubes and aligned in a picking position, wherein said component reception portion is provided with a component receiver holding means (145, 907, 1011) having a fixed position in relation to said at least one fiducial mark, and at least one component receiver (120, 127, 909, 1001), fastened at said component receiver holding means, and defining at least one picking position for the components on said component reception portion.

2. A component magazine according to claim 1, wherein each one of said at least one component receiver (120, 127, 909, 1001) comprises a component positioning surface (141, 603), which is arranged at a predetermined fixed position relative to said component receiver holding means (145, 907, 1011) at which it is fastened, thereby providing a predetermined fixed picking position.

3. A component magazine according to claim 1 or 2, wherein each one of said at least one component receiver (909, 1001) has a snap lock portion (911, 1003), by which it is attached to said component receiver holding means (907, 1011).

4. A component magazine according to any one of claims 1-3, wherein said component receiver holding means (145, 907, 1011) is rigidly connected with said at least one fiducial mark (122, 913).

5. A component magazine according to any one of the preceding claims, wherein said upper part (105) is demountable from said lower part (103).

6. A component magazine according to any one of the preceding claims, wherein said component reception portion is provided with several component receivers.

7. A component magazine according to any one of the preceding claims, wherein said upper part is provided with several fiducial marks.

8. A component magazine according to claim 7, wherein at least two fiducial marks are arranged on opposite sides of said upper part.
